# EUROPEAN PATENT APPLICATION

(11) **EP 4 350 739 A1**
(43) Date of publication of application: **10.04.2024**
(21) Application number: 22814742.7
(22) Date of filing: 16.02.2022
(51) Int. Cl.: H01L 21/02, H01L 21/67

(54) **EPITAXIAL GROWTH METHOD AND EQUIPMENT**

(30) Priority: 01.06.2021 CN 202110607902
(71) Applicant: Wafer Works Epitaxial Corp., Qingpu Shanghai 201707 (CN)
(72) Inventor: CAO, Jianping, Shanghai 201707 (CN); CHEN, Jiangang, Shanghai 201707 (CN); ZHANG, Jian, Shanghai 201707 (CN); SHI, Haifeng, Shanghai 201707 (CN)
(74) Representative: Cabinet Chaillot
(86) International application number: PCT/CN2022/076524
(87) International publication number: WO 2022/252693

(57) **Abstract**

The invention relates to the manufacture of semiconductor devices, and more particularly, to an epitaxial growth method and device. The epitaxial growth method is to provide cooling gas entering a cooling chamber from a reaction gas outlet in an epitaxial growth process. The epitaxial growth device comprises a cooling gas inlet which is distributed in a position, close to the reaction gas outlet, of the cooling chamber. According to the epitaxial growth method and the epitaxial growth device disclosed in the present invention, epitaxial growth of 50 um thick film on a 300 mm silicon wafer can be completed at one time without forming a covering layer on the reaction chamber.

## Description

### BACKGROUND OF THE INVENTION

### 1. Field of the Invention

The invention relates to the manufacture of semiconductor devices, and more particularly, to an epitaxial growth method and device.

### 2. Description of the Related Art

Now in the field of 300 mm silicon epitaxy, a process for achieving epitaxial growth of an epitaxial layer with a thickness of 50 um is generally composed of several steps. The steps are to grow a thin epitaxial layer with a thickness of no more than 10 um in a single time, and its required thickness is obtained by mutiple epitaxial growth of the epitaxial layer. The reason why continuous epitaxial growth in a single time is impossible is that in the epitaxial growth process, temperature in a reaction chamber will gradually increase as time goes on, which in turn increases the occurrence of side effects, that is, impurities in a substrate will escape into the reaction chamber. As a result, the resistivity of the epitaxial layer is affected, the temperature rises and a covering layer forms on an inner surface of the reaction chamber, so that the epitaxial temperature cannot be accurately controlled. The multiple epitaxial growth has the advantage of avoiding the problem of temperature rise due to an excessive reaction time, however, new problem comes. For these epitaxial layers with thick films formed by the mutiple epitaxial growth, doping discontinuities are found at each interface of the epitaxial layer since doping is provided discontinuously.

### SUMMARY OF THE INVENTION

An object of the invention is to provide an epitaxial growth method by which an epitaxial growth of a thick film can be completed on a 300 mm silicon wafer at one time.

In order to achieve the above-mentioned object, in a first aspect of the invention, there is provided an epitaxial growth method, comprising, providing cooling gas entering a cooling chamber from a reaction gas outlet in an epitaxial growth process.

In some embodiments of the first aspect of the invention, the epitaxial growth is done on an N-type superheavy arsenic-doped substrate.

In some embodiments of the first aspect of the invention, the substrate has a resistivity of 0.002-0.003 ohm-cm.

In some embodiments of the first aspect of the invention, a back structure of the substrate is: a silicon dioxide film growing on the substrate, followed by growth of polysilicon, and finally growth of the silicon dioxide film.

In a second aspect of the invention, there is provided an epitaxial growth device, comprising: a cooling gas inlet which is distributed in a position, close to the reaction gas outlet, of the cooling chamber.

In some embodiments of the second aspect of the invention, a trench-like inlet is provided in the cooling chamber in a direction of the reaction gas, a baffle is detachably provided at a portion, close to the reaction gas inlet, of the trench-like inlet, the baffle blocks the part, close to the reaction gas inlet, of the trench-like inlet, so that the cooling gas inlet is formed at the portion, close to the reaction gas outlet, of the trench-like inlet.

According to the epitaxial growth method disclosed in the present invention, epitaxial growth of 50 um thick film on a 300 mm silicon wafer can be completed at one time without forming a covering layer on the reaction chamber.

### BRIEF DESCRIPTION OF THE DRAWINGS

Figure 1 is an SRP diagram of an epitaxial wafer formed by a single growth and an epitaxial wafer formed by multiple growth in an embodiment.
Figure 2 is a temperature comparison diagram of a reaction chamber of an epitaxial furnace.
Figure 3 is a schematic diagram of forming a covering layer in the reaction chamber in the prior art.
Figure 4 is a schematic diagram of the reaction chamber without the covering layer in an embodiment.
Figure 5 is schematic diagram of a structure on a top of a cooling chamber in an embodiment.
Figure 6 is a cross-sectional view taken along A-A of Figure 5.

In the accompanying drawings: 1 a SRP curve of an epitaxial wafer formed by single growth in an embodiment, 2 a SRP curve of an epitaxial wafer formed by multiple growth, 3 fluctuation (at an interface), 4 a curve showing temperatures in a reaction chamber without the addition of a baffle, 5 a curve showing temperatures in a reaction chamber with the addition of the baffle, 100 a cooling chamber, 101 a baffle, 102. a plurality of trenched-like inlets, 110 a cooling gas inlet, 103 a cooling chamber wall, 200 a reaction chamber, 201 a reaction chamber wall, a. cooling gas, b. reaction gas, w. a wafer.

### DETAILED DESCRIPTION

The present invention will now be described more fully hereinafter with reference to the accompanying drawings, in which exemplary embodiments of the invention are shown.

In the prior, a single epitaxial growth of a film with a thickness of for example 50 um cannot be completed, so an epitaxial growth method disclosed in the present invention comprises, providing cooling gas entering a cooling chamber from a reaction gas outlet in an epitaxial growth process. The above-mentioned arrangement is provided for the following reasons. The inventor found that, in the epitaxial growth process, in a flow direction of the reaction gas, the closer to the reaction chamber outlet, the higher the temperature of the reaction gas, and most of the side reactions in the epitaxial deposition process, and a covering layer formed in the reaction chamber is also on the reaction chamber outlet. While the temperature at a reaction gas inlet is relatively lower. The prior art generally focuses on an overall temperature of the reaction chamber, and ignores characteristics of local temperature inside the reaction chamber. The inventor finds out what the problem is and makes full use of the problem. By providing the cooling gas entering the cooling chamber from the reaction gas outlet, cooling at this portion is enhanced, occurrence of the side reactions is effectively reduced, forming of the covering layer on an inner wall of the reaction chamber is avoided. In this way, a single epitaxial growth of a thick film on a 300 mm silicon water can be completed, and doping for the thick film epitaxy is continuous. Thus, cost for the preparation process is greatly reduced, and it is suitable for use in the growth of high-voltage devices.

The substrate has a resistivity of 0.002-0.003 ohm-cm. The back structure of the substrate is: a silicon dioxide film growing on the substrate, followed by growth of polysilicon, and finally growth of the silicon dioxide film. The substrate having the structure can effectively control the escape of impurities from the substrate, thereby reducing the occurrence of self-doping, which is beneficial to the growth of thick film epitaxy.

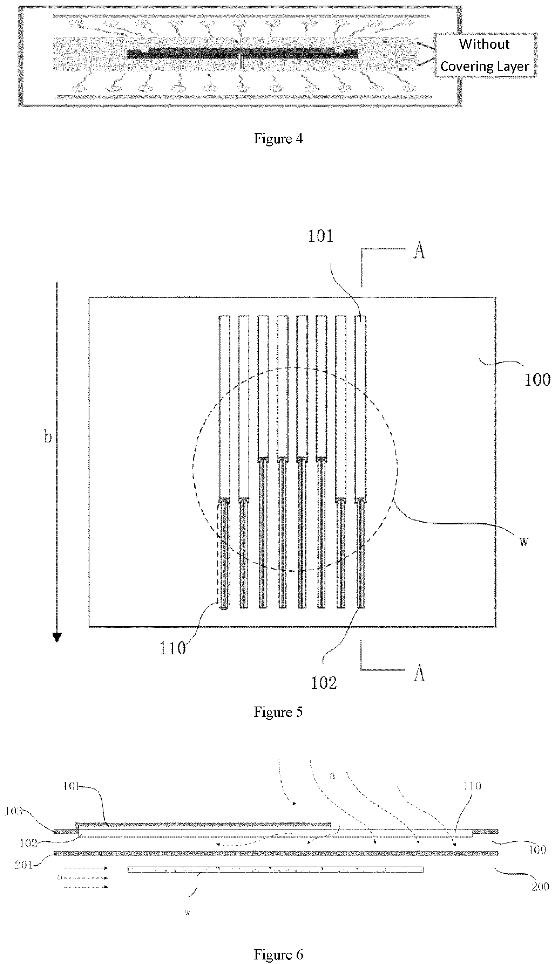

This embodiment further refers to an epitaxial growth device. With reference to Figure 6, a cooling chamber 100 is arranged above a reaction chamber 200. A plurality of trench-like inlets 102 are formed on a cooling chamber wall 103 which is above the cooling chamber 100. By referring to Figure 6 and Figure 5, the plurality of trench-like inlets 102 are provided along a main flow direction of the reaction gas b. In the prior art, the arrangement of those inlets only considers the change of the overall temperature of the reaction furnace, but does not detect the characteristics of local temperature changes inside the reaction chamber. The inventor finds that the main reason why large-size wafers cannot be grown to form ultra-thick epitaxy in a single time is that the temperature of the reaction gas b at an end of the reaction chamber is too high, which leads to more side reactions on the side close to the reaction gas outlet. As a result, the quality of epitaxial growth is affected, and it is easy to form a covering layer on the wall of the reaction chamber on this side. Thus, a cooling gas inlet 110 is distributed in a position, close to the reaction gas outlet, of the cooling chamber 100. Due to the fact that the temperature at the reaction gas outlet is too high and most of the side reactions occur at this side, cooling gas a enters the cooling chamber 100 from a position close to the reaction gas outlet. The cooling gas a enters the cooling chamber 100 via a cooling gas inlet distributed at the position close to the reaction gas outlet, and it is directly blown to a surface of a reaction chamber wall, and exchanges heat with the reaction chamber wall at this position. The cooling gas a is enabled to have a higher flow rate when it is only distributed at the reaction gas outlet instead of being distributed along a whole length in the direction of the reaction gas, so that the cooling gas can directly reach an outer wall of the reaction chamber for sufficient heat exchange, cooling effect of this portion is enhanced, and the possibility of the occurrence of the side reactions is effectively reduced, and forming of the covering layer on an inner wall of the reaction chamber is avoided. In the meantime, pressure from the cooling gas a itself allows a part thereof to reach the reaction gas inlet to properly cool the inlet of the reaction chamber 200. The epitaxial growth device can be used to achieve a single epitaxial growth of a thick film with a thickness of 50 um on a 300 mm silicon water, and doping for the thick film epitaxy is continuous. Thus, cost for the preparation process is greatly reduced, and it is suitable for use in the growth of high-voltage devices.

The above-mentioned structure can be obtained by improving the existing reaction furnace device. Referring to Figure 5, a baffle 101 can be arranged on a portion, close to the reaction gas inlet, of the plurality of trench-like inlets 102, so that the cooling gas inlet 110 can be formed on a portion, close to the reaction gas outlet, of the plurality of trench-like inlets 102. The baffle used herein may be made from materials having good heat dispersion performance, and it may be connected to cooling chamber by welding, or by clamping, or it may be in thread connection with the cooling chamber, for example.

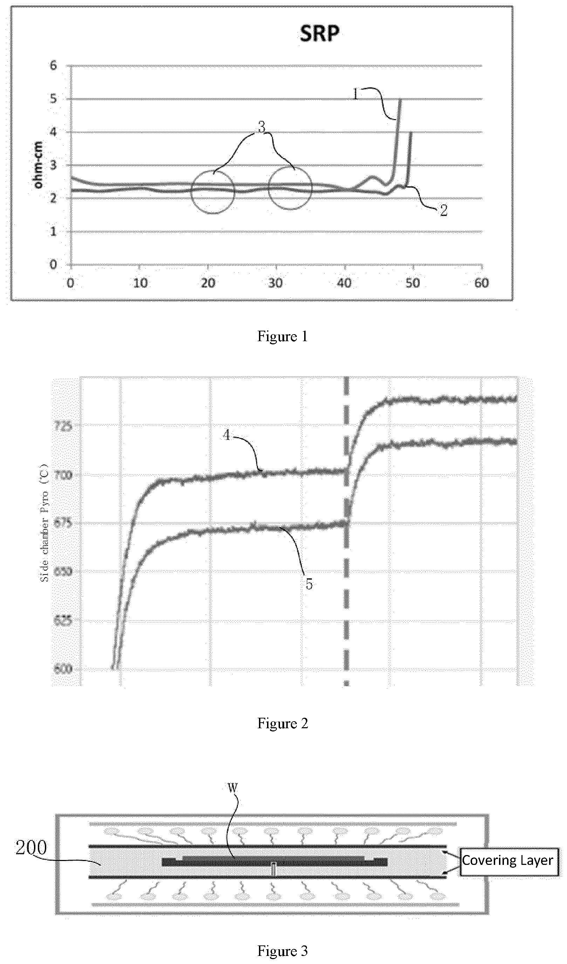

In the actual epitaxial growth process, a 300 mm substrate is put into the epitaxial growth device of this embodiment, and the reaction gas enters the substrate from the reaction gas inlet and flows out from the reaction gas outlet. Epitaxial deposition occurs on a surface of the substrate to form an epitaxial layer. In the epitaxial reaction process, the cooling gas enters from the cooling gas inlet to cool the reaction chamber close to the reaction gas outlet. In this way, the occurrence of the side reactions is effectively suppressed, and a 50 um thick film epitaxial layer is formed finally. Continuous doping is applied to the resulting epitaxial layer, and thus it has a continuous and stable resistivity (see Figure1), thus, cost for the preparation process is greatly reduced, and it is suitable for use in the growth of high-voltage devices.

During the process of the thick film epitaxial growth of large-sized silicon wafers, the reaction gas enters the reaction chamber from the reaction gas inlet, and an epitaxial layer with a predetermined thickness is deposited on a surface of the wafer. The reaction gas is discharged from the reaction gas outlet after passing through the wafer. During the process of the epitaxial growth, due to the restriction of the baffle, the cooling gas enters from the trench-like inlets close to the reaction gas outlet to cool the reaction chamber wall. Since the baffle reduces the length of the trench-like inlets, the cooling gas has a higher flow rate when passing through the trench-like inlets, so that the cooling gas can be directly blown to the surface of the reaction chamber wall for heat exchange. Heat exchange is effectively improved. Compared with a reaction chamber without the baffle under the same conditions, the temperature in a reaction chamber with the baffle can be seen in Figure 2. A temperature curve 5 of the reaction chamber, in which the baffle is added to the trench-like inlet, is significantly lower than a temperature curve 4 of the reaction chamber, in which the baffled is not added to the trench-like inlet, thus ensuring a thick film epitaxy can be formed by single growth. As shown in Figure 1, the SRP curve 2 of an epitaxial wafer formed by multiple growth obviously fluctuates 3 at an interface. Compared with a SRP curve 2 of the epitaxial wafer formed by multiple growth, the SRP curve 1 of the epitaxial wafer formed by a single growth is more stable and continuous, and the quality of the epitaxial wafer is significantly improved.

The above descriptions are only the preferred embodiments of the invention, not thus limiting the embodiments and scope of the invention. Those skilled in the art should be able to realize that the schemes obtained from the content of specification and drawings of the invention are within the scope of the invention.

## Claims

1. An epitaxial growth method, comprising,
providing cooling gas entering a cooling chamber from a reaction gas outlet in an epitaxial growth process.

2. The epitaxial growth method according to claim 1, wherein the epitaxial growth is done on an N-type superheavy arsenic-doped substrate.

3. The epitaxial growth method according to claim 2, wherein the substrate has a resistivity of 0.002-0.003 ohm-cm.

4. The epitaxial growth method according to claim 2, wherein a back structure of the substrate is: a silicon dioxide film growing on the substrate, followed by growth of polysilicon, and finally growth of the silicon dioxide film.

5. An epitaxial growth device, comprising: a cooling gas inlet which is distributed in a position, close to the reaction gas outlet, of the cooling chamber.

6. The epitaxial growth device according to claim 5, wherein a trench-like inlet is provided in the cooling chamber in a direction of the reaction gas, a baffle is detachably provided at a portion, close to the reaction gas inlet, of the trench-like inlet, the baffle blocks the part, close to the reaction gas inlet, of the trench-like inlet, so that the cooling gas inlet is formed at the portion, close to the reaction gas outlet, of the trench-like inlet.
